# EUROPEAN PATENT SPECIFICATION

(11) **EP 1 057 006 B1**
(45) Date of publication and mention of the grant of the patent: **26.01.2011**
(21) Application number: 99906636.8
(22) Date of filing: 04.02.1999
(51) Int. Cl.: G01N 21/35, H01L 35/08, H01L 35/34, G01J 5/12

(54) **A METHOD OF PRODUCING A DETECTOR ARRANGEMENT INCLUDING A GAS SENSOR, AND A DETECTOR ARRANGEMENT PRODUCED IN ACCORDANCE WITH THE METHOD**
VERFAHREN ZUR HERSTELLUNG EINER DETEKTORANORDNUNG EINSCHLIESSLICH EINES GASSENSORS UND MIT DIESEM VERFAHREN HERGESTELLTE DETEKTORANORDNUNG
PROCEDE DE FABRICATION D'UN AGENCEMENT DE DETECTEUR COMPRENANT UN CAPTEUR DE GAZ, ET AGENCEMENT DE DETECTEUR AINSI FABRIQUE

(30) Priority: 17.02.1998 SE 9800462
(43) Date of publication of application: 06.12.2000
(73) Proprietor: Martin, Hans Göran Evald, 820 60 Delsbo (SE); Öhman, Per Ove, 755 91 Uppsala (SE)
(72) Inventor: Martin, Hans Göran Evald, 820 60 Delsbo (SE); Öhman, Per Ove, 755 91 Uppsala (SE)
(74) Representative: Hopfgarten, Nils
(86) International application number: PCT/SE1999/000145
(87) International publication number: WO 1999/041592

(56) References cited:
- CA-A- 2 212 432
- DE-A1- 4 110 653
- US-A- 3 005 097
- US-A- 4 029 521
- US-A- 4 772 790
- US-A- 5 268 782

## Description

### FIELD OF INVENTION

The present invention relates to a method of producing a detector which arrangement belongs to or is associated with a gas sensor and which is intended to detect electromagnetic waves, such as infrared light rays, passing through a gas cell.

This invention is based upon the features mentioned in the preamble of claim 1

Reference to a gas sensor arrangement in the following description implies a device, which includes a gas cell having a cavity in which a gas volume to be evaluated is enclosed or is allowed to pass therethrough, a device that generates electromagnetic waves, such as a light source, which is adapted to emit infrared light rays, a detector adapted to receive the electromagnetic waves generated by said light source subsequent to said rays having travelled along an adapted measuring path within the gas-cell cavity, and an electric or electronic circuit coupled to the detector for evaluating the intensity of the light rays entering the detector and/or to subject said electromagnetic waves to spectral analysis, and therewith determine the structure, concentration and/or the composition of said gas.

More specifically, the present invention relates not only to a method of producing a detector arrangement as a gas cell and having properties relating to the properties of thermocouples but relates also to a detector arrangement produced in accordance with the method and adapted to co-act with a gas cell, either directly or indirectly, as stated in the preamble of claim 11.

### DESCRIPTION OF THE BACKGROUND ART

It has long been known to use light rays or electromagnetic waves in conjunction with absorption spectroscopy, and then particularly light rays within the infrared range, and to use a temperature-sensitive thermal element as a detector, arrangement for instance a thermocouple or a number of thermocouples connected in series, where the thermoelectric effect between two different metals is utilised to generate a voltage difference between a hot and a cold soldering point belonging to said thermocouple. The hot soldering point, or points, is/are placed so as to be exposed by the incident light rays, while corresponding cold solder points are positioned so as to be shadowed from the incident light rays . (See Patent Publication DE.4110653-A1).

It is also known to use thermal elements in the form of Bolometers with which the electromagnetic waves received result in a change in resistance relative to a variation in temperature, and where a number of series-coupled resistance changes are utilised to obtain accurate measuring results.

It is also known to construct gas detector arrangement as sensors or cells that are based on absorption techniques. In a gas detector arrrangement or sensors of this nature, the light rays are allowed to pass through a gas sample contained in the cavity of a gas cell, wherewith certain frequencydependent quantities of the light rays are absorbed by the gas present in the cavity. In this case, a detector is adapted to detect the light rays, and the gas in the cavity, or the concentration of said gas can be determined by evaluating the intensity of the light rays detected in relation to the chosen intensity of the incident light rays and the absorption coefficient with respect to the light concerned, or the electromagnetic wavelength, in the gas in question.

Dectector arrangements based upon sensing temperature gradients due to light obsorption by a thermocouple is shown in US-3005097-A.

It is also known to enable a gas cell to be compressed or made more compact with respect to its physical dimensions, by enabling the light rays to be reflected repeatedly within the cavity such as to obtain a relatively long measuring path (path length) or absorption path in relation to the internal dimensions of the gas cell or the cavity.

Patent Publication US-A-5,009,493 illustrates an example of an absorption gas cell designed to provide an absorption path or measuring path of adapted length within a cavity in which incoming light rays are reflected repeatedly within the cavity before being reflected out of said cavity and falling on a light ray detector arrangement

With gas cells of this nature, it is usual to allow incoming light rays to pass into the cavity through a first opening and to be led out of the cavity through a second opening, wherewith the detector is comprised of a separate part, which is preferably mounted on the gas cell and in the close proximity of the second opening.

The gas cell cavity is normally formed with the aid of at least one first and one second part, whose inner surfaces can be treated individually to provide surfaces that will reflect the incoming light rays. These inner surfaces of the first and second parts are usually coated with one or more metal layers, wherewith the metal layer last applied forms reflecting surfaces or mirror surfaces. The metal used and the method of its application depends on the desired optical qualities of the surfaces and also on the optical wavelength or wavelengths the surfaces shall reflect. The choice of material in the actual body of the gas cell shall also be taken into account.

With respect to the general features of the present invention, it should also be mentioned that it is known to construct small mechanical structures by means of so-called micromechanical or microtechnological methods, where mechanical components are formed on and in a substrate, such as a silicon chip for instance, with the aid of different techniques.

The publication "Combustible Gas Sensor Produced With 3D-Micro Technology", by Tsing Cheng, Landis & Gyr Corporation, Central Research and Development Lab., CH-6301 Zug, Switzerland, illustrates how a compact three-dimensional thermopile can be formed by microtechnological methods.

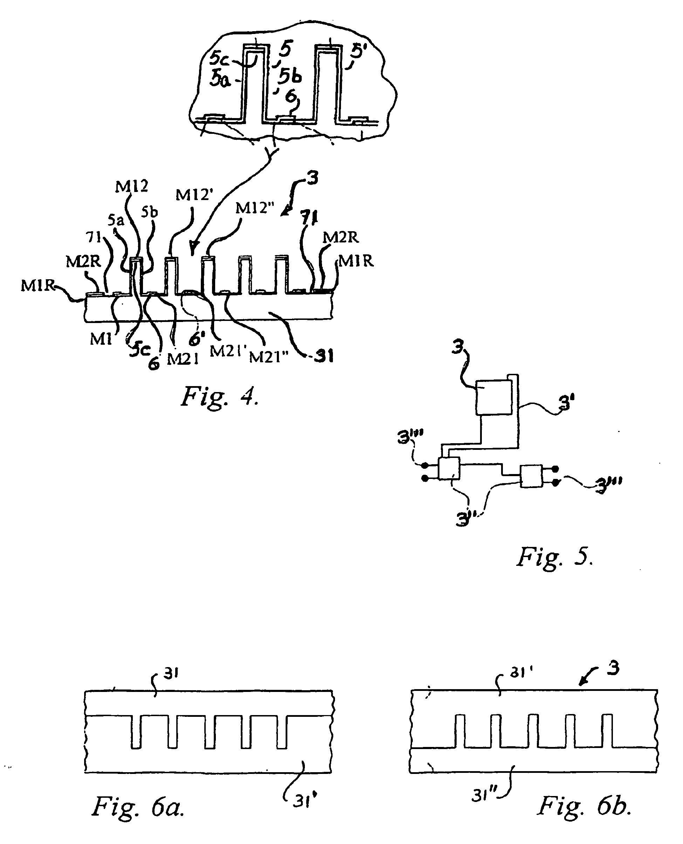

The substrate used in this case is a silicon disc or chip coated with a layer of Si-nitride, which provides effective heat conductivity and effective electric insulation (Fig. 5a). A grating or a number of ridges is/are formed on this surface (Fig. 5b). The grating is coated with metal layers so as to form two different electrical conductors at two different oblique angles (Fig. 5c), therewith forming a plurality of mutually sequential junctions from the one conductor to the other. This results in a stack of thermocouples.

The publication also discloses the possibility of constructing the three-dimensional structure (Fig. 5b) from polyimide.

Also relevant in the present context is a paper published in conjunction with a national conference "Micro Structure Workshop 1996" held in Uppsala, Sweden, March 26-27, 1996, by Olle Larsson, Industrial Microelectronics Center (IMC), Stockholm, Sweden, entitled "Polymeric Microstructures and Replication Techniques", which describes how micromechanically produced models can be replicated by first producing a model that corresponds exactly to the desired copy or replica with the aid of a micromechanical process, and then producing from the model a mould which is complementary to said model and the desired copy or replica, and thereafter producing several copies or replicas with the aid of the mould. A number of ways of carrying out this procedure are described.

Prior publications "Photonics and the Environment", March 1996, illustrates and describes a detector in the form of a Bolometer, and prior publication 0-7803-4412-X/98 § 10.00 (c) 1998 IEEE describes "A Silicon IR-source and CO₂-Chamber for CO₂ Measurements". Both of these publications contribute towards a better understanding of the fundamental principles of the present invention.

### SUMMARY OF THE INVENTION

### TECHNICAL PROBLEMS

When taking into consideration the technical deliberations that a person skilled in this particular art must make in order to provide a solution to one or more technical problems that he/she encounters, it will be seen that on the one hand it is necessary initially to realise the measures and/or the sequence of measures that must be undertaken to this end, and on the other hand to realise which means is/are required to solve one or more of said problems. On this basis, it will be evident that the technical problems listed below are highly relevant to the development of the present invention.

When considering the present state of the art as described above, it will be evident that with respect to a method of producing a detector which arrangement belongs to a gas sensor and a detection arrangement and which are intended to detect electromagnetic waves, such as infrared light rays passing through a gas cell in which there is defined a cavity for enclosing a volume of gas to be measured or evaluated, where the inner surface or parts of the surfaces that form the wall parts of the gas cell or of the cavity are coated with one or more layers of different metals, with the intention of forming a surface that is highly reflective with respect to said light rays or electromagnetic waves, and where the detector is comprised of a thermal element, it will be seen that a problem resides in realising the measures that need to be taken to mass-produce such a detector arrangement in a simple and cost-effective manner, and also in realising how these measures can be implemented.

Another technical problem is one of realising how a detector and the electrically conductive paths and/or other electric and/or electronic components belonging to said detector arrangement can be produced within a limited surface region, around or on a gas cell structure.

Another technical problem is one of realising how a topographic structure produced with high precision in, for instance, a silicon substrate either directly or through the medium of complementary means and representing or corresponding to a detector arrangement and/or a conductor path and/or electric, and/or electronic components can be transferred to form in a plastic material a topographical structure whilst retaining the necessary precision, and then coating the topographical replica with one or more metal layers in a manner known per se so as to form said detector and also, when required, conductor paths, electric and/or electronic components and circuits, and when applicable connection pads.

When a gas cell is comprised of a first and a second part, that may co-act mutually to form said cavity, another technical problem resides in realising those measures that are necessary to form a detector arrangement using an integral part of at least one of said gas-cell parts.

Another technical problem is one of realising how a detector arrangement that has the form of a thermal element and that has been produced in accordance with the present invention shall be positioned and how a topographical pattern shall be formed in a plastic material and also of realising the conditions required to coat the topographical pattern with one or more metal layers and the type of metals that shall be chosen in respect of incident light rays, so as to be able to expose solely the hot solder points or the like to irradiation by the incident light rays and not the cold solder points or the like.

Another technical problem is one of realising what is required to insulate or isolate an integrated thermal element on a reflective metal surface on an electrically insulated body or body part from the remainder of the reflective surface, without needing to employ lithographic methods to this end.

Another technical problem is one of realising how different ridges, belonging to the topographical pattern or three-dimensional structure, can be readily positioned in relation to one another so as to provide a series-coupling of thermal elements that are orientated in rows and columns and therewith provide a very compact detector surface that has a high density of thermal elements, regardless of whether the thermal elements are thermocouples or Bolometers.

Another technical problem is one of realising how the columns and/or rows of ridges shall be interconnected electrically when so required, and electrically isolated from one another when so required, by configuring the topographical structure and by choosing the metal layers and the method of their application in accordance herewith.

Another technical problem is one of realising how the topographical structure shall be formed within the gas cell so as to provide the requisite connecting electrodes for an integrated detector/gas cell, in addition to the thermal element.

Another technical problem is one of realising how the so-called hot solder points or the like shall be adapted to absorb incident light rays, and to realise how the so-called cold solder points or the like shall be adapted to reflect incident light rays, if it should be that the cold solder points or the like would be exposed to incident light rays.

A related technical problem in this regard, particularly when a detector arrangement is adapted to detect infrared light rays, is one of realising how the hot solder points or the like shall be covered by a heat-absorbent layer and how the cold solder points or the like shall be covered by a heat-reflecting layer.

Still another technical problem is one of realising which type of metals shall be used when coating, e.g., the inner wall parts of the first cell-part so as to obtain the intended reflection by said first cell-part and the intended change in resistance or thermoelectric effect of the thermal elements formed.

Another technical problem is one of realising the conditions required to adapt a gas cell so as to provide a plurality of different measurement paths.

With a starting point from an integrated detector/gas cell, another technical problem is one of realising the conditions necessary for mass-producing said integrated/gas cell in a simple and cost-effective manner.

With a starting point from an earlier known thermocouple-forming topographical structure, another technical problem is one of realising the conditions that are required for a similar topographical structure to form a part of the first cell-part, and also to realise the advantages that are afforded hereby.

Another technical problem is one of realising the cost and production advantages that are afforded when one part of a two-part gas cell and a part of the detector surface-section are produced by shaping the same, such as moulding, pressing or embossing, against a die or mould that has a topographical surface section complementary to the topography required for the thermal element, where at least that part of the die or mould, which corresponds to the detector, is produced by electroplating or likewise treatment of a model of a surface section of the detector arrangement, where said model is produced by micromechanically working of a substrate, such as a silicon substrate.

Another technical problem is one of realising the production advantages and cost advantages that are afforded by shaping, such as moulding, pressing or embossing, a part of a two-part gas cell and a part of a surface section of the detector against a complementary model of the detector-associated surface section.

Another technical problem is one of realising the metrological advantages that are afforded by giving the topographical structure a square, or essentially square, extension.

It will be seen that in the case of a square extension, a technical problem is one of providing conditions which enable a plurality of columns of ridges with series-connected thermal elements to be interconnected to form a single series of interconnected thermal elements, particularly thermocouples.

In addition, a technical problem resides in realising the possibilities that are obtained when the detector is adapted to detect infrared light rays and which enables cold and hot solder points or the like, to be adapted to absorb and reflect heat respectively.

### SOLUTION

With a starting point from a method and a detector belonging to a gas sensor and intended for detecting electromagnetic waves, such as infrared light rays, that pass through a gas cell which includes a cavity, adapted for enclosing a volume of gas to be measured or evaluated, where the surface or parts of the surface that form wall parts within the gas cell or the cavity is/are coated with one or more layers of different metals with the intention of forming a surface that is highly reflective to said rays or electromagnetic waves, and wherein the detector is comprised of a thermal element, there is proposed in accordance with the present invention as stated in the pramble of claim 1 and claim 11. with the intention of solving one or more of the aforesaid problems a method and a detector that are characterised by the feature stated in the characterizing parts of claim 1 and claim 11.

According to proposed embodiments that lie within the scope of the present invention, the method and the detector arrangement may expose the features related to the subclaims.

### ADVANTAGES

Those advantages primarily afforded by an inventive method and a detector arrangement, constructed in accordance with said method, reside in the ability of producing a detector arrangement for co-action with a gas sensor in a simple and cost-effective manner and being adapted particularly with regard to concepts of the invention.

According to the invention, a detector arrangement that includes a very large number of series-connected thermal elements can be produced in large volumes and with great precision. This enables detector arrangements integrated in a gas cell to be mass-produced, said detector arrangement being highly sensitive as a result of the large number of series-connected thermal elements and being optically well aligned in the measuring path.

The necessary detector arrangement model is produced with high precision by micromechanically working, e.g., a silicon base structure and the model transferred to a die or mould used in the mass production of gas cell base structures, for instance in a plastic material.

The advantages afforded by a method and/or a detector arrangement, according to the present invention, are applicable with respect to production, enabled by simple high precision manufacture, and with regard to cost by enabling the mass production of sensitive and effectively aligned detector arrangements that are especially adapted with respect to their application.

The primary characteristic features of an inventive method are set forth in the characterising clause of the following Claim 1, while the primary characteristic features of an inventive detector are arrangement set forth in the characterising clause of the following Claim 11.

### BRIEF DESCRIPTION OF THE DRAWINGS

A method and a gas detector arrangement having features characteristic of the present invention will now be described in more detail by way of example, with reference to the accompanying drawings, in which;
- Figure 1: is a higly simplified, schematic illustration of a gas detector arrangement, using a gas sensor built-up on a plate or base structure and including a two-part gas cell, whose one part is shown over a bottom part on which a detector arrangement and a light generating first device are fastened and which is adapted according to the specifications given in accordance with the present invention;
- Figure 2: is a schematic, side view of a portion of a first cell part, according to Figure 1;
- Figure 3: is a schematic, somewhat enlarged, side view of an inventive detector arrangement;
- Figure 4: illustrates a detector arrangement, according to Figure 3, that includes two layers of different metals which form a number of series-connected thermal elements, in the form of thermocouples;
- Figure 5: is a highly simplified and schematic illustra- tion of a possible conductor path, electric and/or electronic circuits, and connection pads that can be formed in accordance with the in- vention;
- Figures 6a and 6b: are schematic side views that illustrate how a detector-adapted base structure can be formed from a die or mould and a model;
- Figure 7: illustrates a discrete detector arrangement, applied to a part belonging to a gas cell;
- Figure 8: is a simplified illustration in side view that shows how a detector arrangement can be aligned or posi- tioned in relation to a chosen angle of inci- dence of light rays;
- Figure 9: illustrates schematically and from above how a detector arrangement can be isolated electrically from a surrounding metal layer;
- Figure 10: is a schematic side view showing how a detector arrangement can be isolated electrically from a surrounding metal layer;
- Figure 11: illustrates schematically and from above a de- tector arrangement that includes a plurality of columns of conductive ridges, and shows the columns inter- connected electrically;
- Figure 12: illustrates schematically and from above a de- tector arrangement according to Figure 11 with which the columns are interconnected electrically by means of electrically conductive surface sec- tions;
- Figure 13: illustrates schematically and from above how conductive and insulating ridges co-act to form a detector arrangement that may include a plurality of col- umns of conductive ridges;
- Figure 14: illustrates schematically and in side view how conductive ridges can be adapted to absorb in- cident light rays; and
- Figure 15: is a highly simplified, schematic illustration of a gas cell where the inner surfaces of the gas cell cavity have been provided with a num- ber of detectors arrangements.

### DESCRIPTION OF EMBODIMENTS AT PRESENT PREFERRED

The invention relates to a method of, inter alia, producing a gas detector arrangement.

The method is described more succinctly in the following method Claims.

Consequently, the following description deals mainly with the detector arrangement.

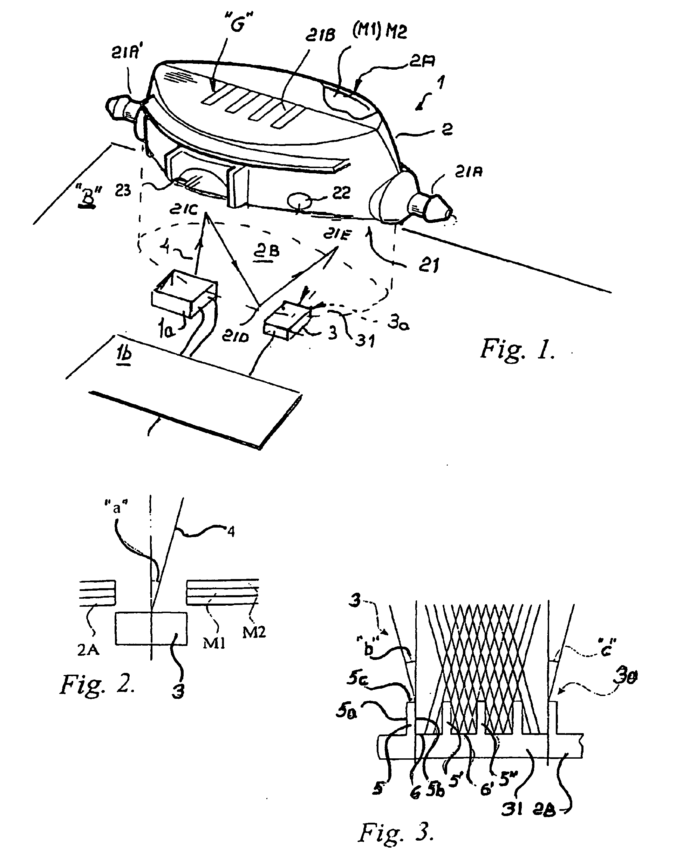

Figure 1 thus illustrates, among other things, a gas detector arrangement or 3, which is adapted to include a gas sensor 1, and its components.

The illustrated kind of gas sensor 1 includes a gas cell 2 in which there is defined a cavity 21 that includes openings 21A, 21A' and/or openings 21B through which a volume of gas "G" to be measured or evaluated can enter and leave said cavity 21.

A first device la for generating infrared light rays is adapted to generate light rays 4 and to direct the rays into the cavity 21.

The light rays 4 can be caused to reflect repeatedly against mutually opposing sections of the walls defining said cavity, such as the illustrated wall sections 21C, 21D and 21E, and thereafter pass to a receiving detector 3.

The detector 3 has connected thereto one or more electric circuits or electronic circuits 1b which function to evaluate the intensity of the light received in the detector 3 and to evaluate the properties and/or the concentration of the gas "G" on the basis of the intensity of the lights emitted in the first device 1a, among other things.

The gas cell 2 can be conceivably designed so that electromagnetic waves, such as light rays 4, entering the cavity 21 will fall on the detector 3 either directly or, as shown, after having been reflected an adapted number of times within the cavity 21. This latter alternative enables the light rays to cover an adapted path length or measuring path within the cavity 21, which may be necessary in absorption spectroscopy, for instance.

The gas cell 2 is normally constructed with the aid of a plurality of mechanical parts.

As will be seen from Figure 1, the gas cell 2 is comprised of a combination of a first part or component 2A and a second part or component 2B, of which at least part 2A is made of a plastic material and has been formed by some sort of moulding or pressing process or by embossment against a die or mould, such as to enable the interior of the gas cell 2 to be given an adapted interior shape, i.e. in the interior of the cavity 21. In the illustrated case, the second part 2B may consist in a flat plate "B" or a base structure.

The illustrated parts 2A and 2B are both made of a plastic material and their respective inner surfaces and/or wall parts have been provided with an electrically conductive metal layer, so that said surfaces or wall parts will be highly light-reflective.

The light generating first device 1a, of the Figure 1 embodiment, has been shown in the form of a separate component lying on a supporting base or plate "B". The detector 3 is also shown as a separate component.

It will be apparent from the following description that these components can be integrated either with the part 2A or in the surface of the base structure "B".

In the Figure 2 embodiment, the surfaces 21C, 21D and 21E that form the wall parts within the gas cell 2, or at least a part of said surfaces 21C, 21D and 21E, are usually coated with two different metal layers M1, M2, that consist of a selected first metal, in a first layer M1, and a selected second metal, in a second layer M2, this second layer being intended to form a highly reflective surface with respect to said light rays 4, therewith enabling practically loss-free reflections to be achieved.

In the case of one application of this kind, the detector 3 is usually mounted in the close proximity of the gas cell 2at a light-ray exit opening 22. In one design of the gas cell, there is formed a number of reflection surfaces which are so orientated that light rays 4 entering the gas cell 2 through an inlet opening 23 and allocated a predetermined direction into the gas cell 2 or the cavity 21, will be reflected through the cavity 21 in accordance with a predetermined pattern 21C, 21D and 21E and fall on the detector 3 at a predetermined angle of incidence "a" (Figure 2).

International Patent Application PCT/SE96/01448, with Publication No. WO 97/187460, and the International Patent Application PCT/SE97/01366, with Publication No. WO 98/09152, disclose examples of earlier known gas sensors, in which incoming light rays are repeatedly reflected within the cavity in accordance with a predetermined pattern.

It is important that the detector 3 is aligned with respect to this angle of incidence "a" in the best possible way, so as to obtain a sufficiently good measuring signal. It is also important that the detector 3 has sufficiently high sensitivity to the signal to be detected.

Light sources that generate light rays in the infrared wavelength range are often used in conjunction with absorption spectroscopy, and consequently it is usual to use detector consisting of thermal elements.

It is also known to use thermal elements in the form of temperature dependent resistance elements, such as Bolometers, or thermoelectric elements or thermocouples. The sensitivity of these elements is usually enhanced, by connecting several such elements in series.

The following description is concentrated, to a large extent, on the measures required to construct a detector 3 in the form of a number of series-connected thermocouples.

Those skilled in this art will realise that the following proposals can be modified appropriately to provide series-connected resistance paths for a Bolometer.

According to the invention, at least the detector 3 constitutes a part of a surface. This surface may consist in an outer part within the wall parts of the cavity 21 and "cover" the opening 22 with connection lines drawn down towards the supporting base B in connection with the detector 3 of the Figure 1 illustration, where requisite connecting pads are formed.

The detector 3 may alternatively be formed within a surface part of the part 2B that lies closely adjacent to the location of the gas cell 2, wherewith said part 2A is provided with a 45° reflectance surface immediately above said surface part and "covering" the opening 22.

Figure 3 shows, in accordance with the present invention, that the detector 3 is formed specifically on a body having the form of an underlying or base surface 31 or a part of a larger underlying supporting base surface "B". In this case, that part of the underlying support surface 31 that forms the actual detector 3 is comprised of one or more surface regions 3a formed topographically in a plastic element.

At least the surface region or regions 3a is/are coated with a first and a second electrically conductive metal layer M1, M2, these layers being intended to form a thermocouple in accordance with Figure 4.

Those persons skilled in this particular art will realise that a Bolometer requires only a first electrically conductive metal layer on the topographically formed surface region.

In this case, the topographic structure shall form,from the electrically conductive layer, a loop whose electrical resistance varies with temperature. It is also possible to form a first and a second loop by means of a topographic structure, where the first loop is allowed to be exposed to incident light rays and where the second loop is in the shadow of incident light rays as a result of the topographic structure, therewith enabling compensation to be made for variations in background temperature.

In order to obtain a chosen conductive pattern, an electric and/or an electronic circuit and/or electric or electronic components, there is required a well-developed topographic configuration on the chosen surface region of the plastic element, and a particular metal coating application.

All persons skilled in this particular field are capable of creating a topographic pattern on an electrically insulating plate that will provide a desired printed circuit or the like subsequent to applying a metal layer or layers thereto.

It will be understood that in the illustrated case, the first metal layer M1 is applied to the surface region concerned at a first angle "b", other than 90° or the normal, and that the second metal layer M2 is applied at a second angle "c", other than 90° and differing from the first angle "b". These angles "b" and "c" normally lie in one and the same plane, as illustrated in Figure 3,

The topographic structure and/or the form 3a provided with electrically conductive coatings provides the function of one or more several thermocouples, by virtue of the first and the second metal layers M1, M2 being allowed to overlap within discrete surface parts of the detector.

Figure 5 shows the possibility of producing the detector 3 on a restricted surface region and to produce requisite electric circuitry 3' and/or electric and/or electronic circuits 3" and requisite connection pads 3''' within this restricted surface region in the same way as that described above, i.e. by coating a topographic structure with one or more metal layers from different angles.

As illustrated in Figure 6a, it is proposed, in accordance with the invention, that the underlying support surface 31 is produced by shaping, such as moulding, pressing or embossing, against a die or mould 31', where at leats a part of the mould corresponding to the detector 3, according to Figure 6b, is produced by electroplating a model 31'' of the detector 3, said model 31'' being produced by micromechanically working a substrate, such as a silicon substrate, where the topographic structure and/or configuration of the model 31'' is chosen to correspond to desired surface parts of the detector, electric conductor paths and/or electric and/or electronic circuits.

Alternatively, the base unit 31 shown in Figure 6a can be produced by shaping, such as moulding, pressing or embossing, said unit against a die or mould 31', where at least a part of the mould corresponds to the detector 3 produced by micromechanically working a substrate, such as a silicon substrate, where the topographical structure and/or configuration of the substrate 31' is complementarily dependent on desired detector-associated surface parts, electric conductor paths and/or electrical and/or electronic circuits.

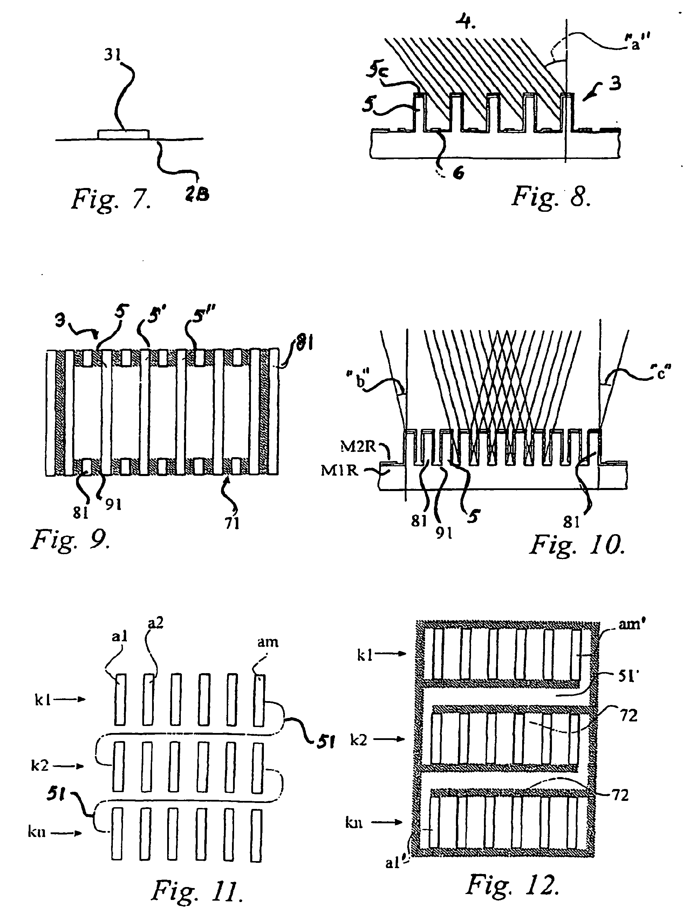

Figure 7 shows that a base unit 31 may consist of a discrete of separate component and applied to the first part 2A.

However, the most favourable embodiment for integrating the detector 3 said cavity is that shown in Figure 3, where the base unit 31 constitutes an integral part of the first cell-part 2A, and where the detector-associated surface parts are an integral part of the surface belonging to said cavity 21.

Regardless of whether the base unit 31 is a discrete component, in accordance with Figure 7, or an integral part of the first cell-part 2A, it is possible to coat the cavityassociated surface sections and the detector-associated surface parts at one and the same time, preferably with the same metal.

The present invention also enables the topographic structure to be adapted to provide the requisite connection pads 3''' belonging to said detector 3, electric conductor paths 3, and/or electric and/or electronic circuits 3'' as illustrated in Figure 5.

Alternatively, the electric conductor paths 3' and/or the electric and/or the electronic circuits 3'' can be formed in the second part 2B.

According to the present invention, the formed detector 3 may comprise an integral part of the first cell-part 2A, as illustrated in Figure 3. It is assumed in the remainder of the description that such is the case. The person skilled in this art will understand how the present method shall be applied when the formed detector does not constitute an integral part of the first cell-part 2A.

It is particularly convenient (Figure 8) to provide the base unit with a number of conductive ridges 5, 5', 5''. Each of these conductive ridges has a first side surface 5a, a second side surface 5b and an upper surface 5c. (Figure 4) An intermediate surface 6, designated here a conductive surface, is located between two mutually adjacent conductive ridges 5, 5'.

It should perhaps be mentioned that the expression "conductive ridges" may be somewhat misleading, since the topographic structure has the form of a greatly reduced "skyscraper structure", i.e. the structure is comprised of a plurality of narrow rods, where the rods in one row (or column) may be slightly offset laterally with respect to the rods in adjacent alternate rows and with different rods of different heights.

As previously described with reference to Figures 3 and 4, the electrically non-conductive base unit 31 is coated with the first metal M1 at a first angle "b" in relation to the detector surface, and with the second metal M2 at a second angle "c" relative to said detector surface.

The first angle "b" shall be adapted so that the first side surface 5a and at least a part of the upper surface 5c of respective conductive ridges 5, 5', 5'', and at least a part of the intermediate conductive surfaces 6 will be coated with the first metal layer M1, and the second angel "c" shall be adapted so that the second side surface 5b and at least a part of the upper surface 5c of respective conductive ridges 5, 5', 5'', and at least a part of the intermediate conductive surfaces 6 will be coated with the second metal layer M2, in accordance with Figures. 3 and 4.

The first and the second angles "b", "c" shall be adapted so that the second metal layer M2 overlaps the first metal layer M1 on the upper surface 5c of respective conductive ridges 5, 5' and on the intermediate conductive surfaces 6, 6' so as to form an electric contact with M12, M21, and so that the metal layers M1, M2 will form a series of electrically coupled ridges or transitions M12, M12', M21, M21' between the first and the second metals.

As evident from Figure 4, this results in a series of thermal elements, where the number of series-connected thermal elements corresponds to the number of ridges. In order to obtain an electrically functioning detector 3, it is necessary for all thermal elements to be insulated electrically from surrounding metal layers, i.e. that the metal layers M1. M2 in the detector-associated surface are electrically isolated at 71 from the metal layers M1R, M2R on the surrounding surface.

As illustrated in Figure 8, it is proposed, in accordance with the present invention, that the integrated part is aligned relative to the angle of incidence "a" of the incident light 4 by positioning the detector 3 in relation to incident light rays 4, such that said rays will irradiate the upper surface 5c of respective conductive ridges, and such that the intermediate conductive surfaces 6 will lie in the shade of the conductive ridges with respect to incident light rays 4.

As will be seen from Figures 9 and 10, electric isolation, or insulation 71, between the detector 3 and surrounding metal layers M1R, M2R is achieved with the aid of insulating ridges 81 with adjacent insulating surfaces 91 belonging to the integrated part are so positioned relative to each other and relative to the conductive ridges 5, 5', 5'' and relative to the first and to the second angle "b", "c" that both the first metal coating M1 and the second metal coating M2 will be absent on the insulated surfaces 71.

Figures 9 and 10 also show how a column of ridges is constructed. It is desirable to obtain a large number of series-coupled transitions from one metal to the other metal, in order to enhance the resolution, or sensitivity, of the detector 3. If it is necessary to increase the number of series-connected transitions, the detector surface will obtain a pronounced oblong shape. For reasons of measuring technology, however, it is desirable for the detector surface to have an essentially square shape.

Accordingly, it is proposed, in accordance with the invention, that the conductive ridges have a configuration which comprises a number of columns of mutually parallel conductive ridges, as shown in Figure 11, where the number of columns is "n", here designated column 1 (k1), column 2 (k2), and so on to column "n" (kn) where the number of conductive ridges in respective columns is "m", here designated ridge 1 (a1), ridge 2 (a2) and so on up to ridge "m" (am) and where "m" may be different for respective columns.

In order for the ridges in respective columns to form a coherent series of junctions, it is proposed in accordance with the invention that the "m"th ridge "am" of each column, with the exception of the last column "kn", is coupled electrically 51 to the first ridge "a1" of the next following column.

In this way, the transitions between the first and the second metals belonging to all conductive ridges within all columns form a common series of electrically coupled junctions.

Figure 12 illustrates an embodiment in which the electric interconnection 51 (Figure11) between two ridges of two mutually adjacent columns "k1", "k2" can be effected by forming an electrically conductive surface section 51' as said interconnection.

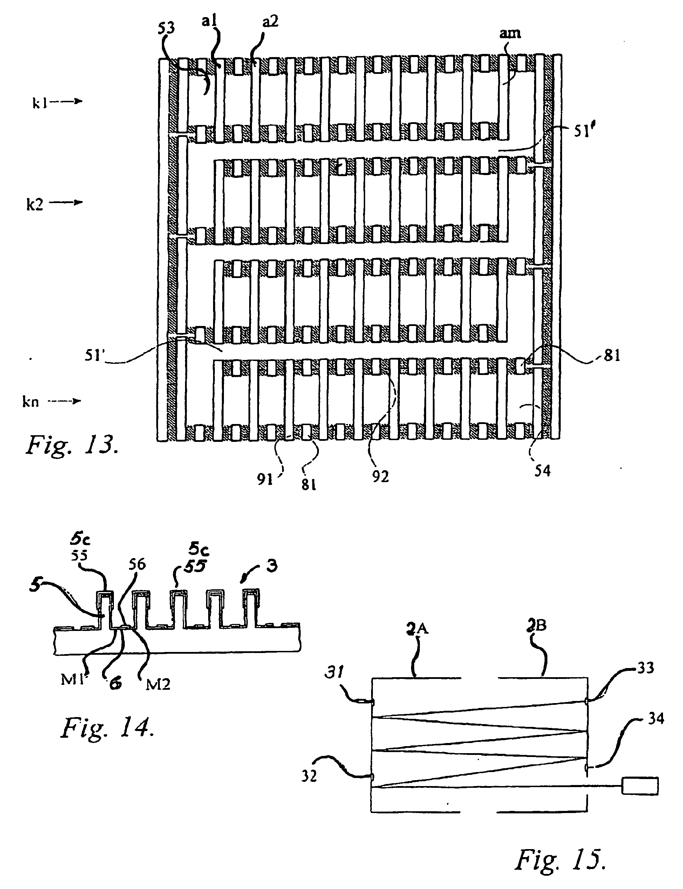

Figure 13 illustrates that an essentially square thermocouple can be constructed by combining electrically conductive ridges "a1", "a2" with insulating ridges 81.

It is also suggested, in accordance with the present invention, that the series of electrically conductive ridges form the series-connected thermocouples, where the metal layer on a first or on a second side surface of a first conductive ridge "k1", "a1", or a conductive surface adjacent said first conductive ridge, in the series of conductive ridges forms a first connection electrode 53 on the (Figure 3) series-connected thermocouple, and that a first or a second side surface of a last conductive ridge "kn", "am", or a conductive surface adjacent said last conductive ridge, in the series of conductive ridges, forms a second connection electrode 54 on the series-connected thermocouple.

Figure 14 is intended to show in particular that when the detector 3 is adapted to detect light rays within the infrared wavelength range, the upper surface 5c of a respective conductive ridge may be covered with a heat-absorbent layer 55 and the intermediate conductive surfaces 6 covered with a heat-reflecting layer 56.

This is done so that the hot solder points,constituting measuring points in the thermocouple and exposed to the incident light rays, shall absorb the greatest possible part of the thermal energy present in incident light rays or beams. The cold solder points, i.e. the conductive surfaces between the conductive ridges, shall not be subjected to incident light rays and are therefore shaded by the conductive ridges, as earlier described. However, certain amounts of stray light may occur in the cavity, and consequently it is desirable and appropriate to cover the cold solder points, with a heat-reflecting layer.

According to one preferred embodiment of the invention, the heat-absorbent coating 55 is comprised of a layer of carbon, whereas the heat-absorbent coating 56 is comprised of the reflective metal layers M1, M2.

The metal in one of the two metal layers M1 has a first reflection coefficient in relation to the light rays 4 and the metal in the other of the two metal layers M2 has a second reflection coefficient in relation to the light rays 4. As can be seen from Figure 8 the incident light forms an angle "a" in relation to the detector-associated surface parts.

In order to limit the amount of light that is reflected down between two adjacent ridges it is proposed that these are positioned relatives to incident light rays so that the metal with the lowest reflection coefficient of the two reflection coefficients is the metal covering the side surface 5a that will face the incident light rays.

The two metals M1, M2 used shall be appropriate both with respect to optical properties, reflection of utilised light rays, and also with respect to their thermoelectric properties. Thus, the first metal M1 shall differ from the second metal M2 and said metals shall provide a thermoelectric effect in co-action with one another.

According to one preferred embodiment, the two metals are gold and chromium respectively, where chromium is the first, innermost metal M1, and gold is the second metal M2.

This is specifically advantageous if the detector 3 is an integral part of the gas cell, since gold, on top of chromium, has very good optical characteristics.

It shall be noted that if the detector is not an integral part of the gas-cell, but is manufactured by itself and applied to the gas cell, or if the wall parts of the cavity in the gas cell can be covered as the two metals are applied to the surface regions of the detector, for instance through masking, then other metals can be used with more advantageous thermoelectric characteristics.

It will also be understood that a gas cell can be provided or allocated with a plurality of detectors, within the concept of the invention. This possibility is illustrated in Figure 15, in which the first part 2A includes integrally two or more different detectors 31, 32, and/or by providing the second part 2B or further second parts with one or more detectors 33, 34.

The term rays of electromagnetic waves, light beams, and more specifically light rays or beams within the infrared wavelength range or infrared light has been used generally in this description. It will be understood, however, that the present invention is not restricted specifically to infrared light and that all rays of electromagnetic waves that can be detected by thermocouples or the like can be used, such as electromagnetic waves within the microwave range, for instance.

It is pointed out that with the intention of facilitating an understanding of the invention, the devices and apparatus illustrated have been greatly enlarged and greatly simplified. In practical applications, the cavity in a gas cell will have dimensions in the regions of millimetres or a centimetre, whilst the detector and its ridges will have dimensions in the micrometer range. However, the present invention is not restricted to specific sizes of the components and said components may have any desired dimensions, in accordance with the requirements that prevail in respect of a particular application.

It will be understood that the invention is not restricted to the aforedescribed and illustrated exemplifying embodiments thereof, and that modifications can be made within the invention as defined the following Claims.

## Claims

1. A method of forming a detector-arrangement, comprising a gas sensor (1), in the form of a gas cell (2), having a defined interior cavity (21), that includes openings (21A; 21A'; 21B), through which a volume of gas (G), to be measured or evaluated, is to be entered and to be left; a device (1a) for generating infrared light rays (4) and to direct said light rays (4) into said cavity (21), said light rays (4) are caused to reflect repeatedly against mutually opposing inner sections (21C, 21D and 21E) defining said interior cavity (21); a detector (3) for receiving said reflected light rays (4); and one or more electric circuits or electronic circuits (1b), adapted to evaluate the intensity of the light rays (4) thus received and to evaluate the properties and/or the concentration of the gas (G) on the basis of the intensity of the light rays (4) transmitted by said device (1a) for generating infrared light rays (4), said gas cell (2) and its inner sections are formed as wall-parts, covered with different metal layers to form a surface which is highly reflective with regard to said light rays, as electromagnetic waves, and wherein said detector (3) is formed as a thermal or thermocouple element, detecting heat generated by light rays passing cavity (21) and said gas, **characterised by** using an electrically non-conductive base structure (B), and to form thereon an electric circuit or an electronic circuit (1b), one or more surface regions of said base structure (B) is formed as a topographical structure; in that at least one surface region or surface regions, exhibiting said topographical structure, is per se to be covered with electrically conductive metal layers to form a thermocouple, in that a first metal layer (M1) is to be applied to the topographical structure at a first angle of incidence, other than 90° in relation to a surface plane; in that a second metal layer (M2) is to be applied to said structure at a second angle of incidence other than 90°; and different to said first angle, in that said first and said second metal layers (M1; M2) are caused to overlap each other within discrete surface parts of said topographical structure to form said thermocouple, in that said first metal layer (M1) and said second metal layer (M2) are comprised of metals which provide the function of said thermocouple at said discrete surface parts, that said detector (3) is formed within a limited surface region of said base structure (B); and that electric conductors and/or said electric circuit and/or said electronic circuit (1b) are formed adjacent said limited surface region, in the same way by coating a topographic structure with one or more metal layers from different angles, that said topographical structure is formed to provide requisite connection pads, belonging to said detector (3), electric conductors, and/or electric and/or electronic circuits (1b).

2. A method according to Claim 1, **characterised in that** said thermocouple element is formed to expose a Bolometer.

3. A method according to Claim 1, in which said gas cell (2) is formed by using a first (2A) and a second (2B) part, which together are forming said cavity (21), **characterised in that** onto said base structure is said first part (2A) applied.

4. A method according to Claim 1, in which said gas cell (2) is formed by using a first (2A) and a second (2B) part, which together is defining said cavity (21), **characterised in that** said base structure (B) is formed as a part integral with said second part (2B); and **in that** surface parts are formed as a part of the inner section or surface of said cavity (21).

5. A method according to Claim 1, **characterised in that** the topographical structure includes a number of conductive ridges; wherein a conductive surface is located between two adjacent conductive ridges; and wherein the upper surface of respective conductive ridges is covered with a heat absorbing layer comprised of carbon; and the intermediate conductive surfaces are covered with a heat-reflecting layer comprised of said metal layers.

6. A method according to Claim 1, **characterised in that** a metal layer (M1; M2), in one of two metal layers (M1; M2), has a first reflection coefficient in relation to said light rays, that a metal layer (M1; M2) in the other of two metal layers (M1; M2), has a second reflection coefficient, in relation to said light rays, and that a detector-associated surface part on said base structure (B) is positioned relative to incident light rays, so that a metal having a lowest reflection coefficient of said two reflection coefficients, is the metal covering a side surface, that will face said incident light rays.

7. A method according to Claim 1, **characterised in that** a used metal in a first metal layer differs from a used metal in a second metal layer, such as to obtain a thermoelectric effect, between said first and said second metal layers.

8. A method according to Claim 1 or 7, **characterised in that** said two metal layers are comprised of gold covering chromium.

9. A method according to Claim 1, **characterised in that** a first gas cell related wall part (2A) covers a surface section (2B) intended for two or more different detectors (3).

10. A method according to Claim 1, **characterised in that** a first gas cell part related wall (2A) has a surface section intended for two or more detectors (3).

11. A detector arrangement, comprising a gas sensor (1), in the form of a gas cell (2), having a defined interior cavity (21), that includes openings (21A, 21A'; 21B), through which a volume of gas (G), to be measured or evaluated, is to be entered and to be left; a device (1a) for generating infrared light rays (4) and to direct said light rays (4) into said cavity (21), said light rays (4) are caused to reflect repeatedly against mutually opposing inner sections (21C, 21D and 21E) defining said interior cavity (21); a detector (3) for receiving said reflected light rays (4); and one or more electric circuits or electronic circuits (1b), adapted to evaluate the intensity of the light rays (4) thus received and to evaluate the properties and/or the concentration of the gas (G) on the basis of the intensity of the light rays (4), transmitted by said device (1a), said gas cell (2) and its inner sections are formed as wall-parts covered with different metal layers to form a surface, which is highly reflective with regard to said light rays as electromagnetic waves, and wherein said detector (3) is formed as a thermal or thermocouple element, detecting heat generated by light rays passing said cavity (21) and said gas, **characterised in that** onto an electrically non-conductive base structure (B) and a part thereof is formed an electric circuit or an electronic circuit (1b), one or more surface regions of said base structure (B) is formed as a topographical structure; **in that** at least one surface region or surface regions, exhibiting said topographical structure, is covered with electrically conductive metal layers (M1; M2) to form said thermocouple element; **in that** a first metal layer (M1) is applied to the topographical structure at a first angle of incidence, other than 90° in relation to a surface plane; **in that** a second metal layer (M2) is applied to said structures at a second angle, other than 90° and different to said first angle of incidence, wherewith said first and said second metal layers mutually overlap each other within discrete surface parts of said topographical structure, to form said thermocouple, **in that** said first and said second metal layers (M1; M2) are comprised of metals which provide the function of said thermocouple at said discrete surface parts, that said detector (3) is formed within a limited surface area of said base structure (B); and that electrical conductors and/or said electrical circuits and/or said electronic circuits are provided adjacent said limited surface area in the same way by coating a topographical structure with one or more metal layers (M1; M2) from different angles, that said topographical structure is adapted to provide requisite connection pads, belonging to said detector, electric conductor paths, and/or electric and/or electronic circuits.

12. A detector arrangement according to Claim 11, **characterised in that** said thermal element is formed as a series-connected resistances and functions as a Bolometer.

13. A detector arrangement according to Claim 11, where a gas cell is comprised of a first (2A) and a second (2B) part, that are intended to mutually co-act to form said cavity (21), **characterised in that** onto said base structure (B) is applied and attached said first part (2A).

14. A detector arrangement according to Claim 11, wherein sad gas cell (2) is comprised of a first (2A) and a second (2B) part, which are intended to co-act to form said cavity (21), **characterised in that** to said base structure forms an integral part of said second part (2B); and **in that** surface parts form an integral part of the inner surface of said cavity (21).

15. A detector arrangement according to Claim 11, **characterised in that** the topographical structure includes a number of conductive ridges; wherein a conductive surface is located between two adjacent conductive ridges; and wherein the upper surface of respective conductive ridges is covered with a heat absorbing layer comprised of carbon, end the intermediate conductive surfaces are covered with a heat-reflecting layer comprised of said metal layers.

16. A detector arrangement according to Claim 11, **characterised in that** a metal layer in one of two metal layers, has a first reflection coefficient, in relation to said light rays, that a metal layer in the other of two metal layers has a second reflection coefficient, in relation to said light rays, and that a detector-associated surface part is positioned relative to incident light rays, so that the metal with a lowest reflection coefficient of said two reflection coefficients is the metal covering a side surface that will face said incident light rays.

17. A detector arrangement according to Claim 11, **characterised in that** a metal of a first metal layer is different from a metal of a second metal layer, such as to obtain a thermoelectric effect between said first and said second metal layers and **in that** said two metal layers are comprised of gold covering chromium.

18. A detector arrangement according to Claim 11, **characterised in that** a first gas cell related wall part (2A) is covering a surface section (2B) intended for two or more detectors (3).

19. A detector arrangement according to Claim 11, **characterised in that** said first gas cell related wall part (2A) has a surface section intended for one or more detectors (3).

## Patentansprüche

1. Verfahren zur Bildung einer Detektoranordnung, welche einen Gassensor (1) in Form einer Gaszelle (2), die einen definierten inneren Hohlraum (21) umfasst, der Öffnungen (21A, 21A', 21B) umfasst, durch welche ein Volumen eines Gases (G), welches gemessen oder ausgewertet werden soll, eingefüllt und dort belassen wird; eine Vorrichtung (1a) zum Erzeugen von Infrarotlichtstrahlen (4) und zum Leiten der Lichtstrahlen (4) in den Hohlraum (21), wobei bewirkt wird, dass die Lichtstrahlen (4) wiederholt an sich gegenüberliegenden inneren Abschnitten (21C, 21D und 21E) reflektiert werden, welche den inneren Hohlraum (21) definieren; einen Detektor (3) zum Empfang der reflektierten Lichtstrahlen (4) und eine oder mehrere elektrische Schaltungen oder elektronische Schaltungen (1b) umfasst, welche dafür geeignet sind, die Intensität der so empfangenen Lichtstrahlen (4) auszuwerten und die Eigenschaften und/oder die Konzentration des Gases (G) auf der Grundlage der Intensität der Lichtstrahlen (4) auszuwerten, die von der Vorrichtung (1a) zum Erzeugen von Infrarotlichtstrahlen (4) ausgesendet werden, wobei die Gaszelle (2) und ihre inneren Abschnitte als Wandteile ausgebildet sind, welche mit unterschiedlichen Metallschichten bedeckt sind, um eine Oberfläche zu bilden, welche für die Lichtstrahlen als elektromagnetische Wellen stark reflektierend ist, und wobei der Detektor (3) als Thermoelement oder thermoelektrisches Element ausgebildet ist, welches Wärme erfasst, die von Lichtstrahlen erzeugt wird, die durch den Hohlraum (21) und das Gas hindurch gelangen, **dadurch gekennzeichnet, dass** eine elektrisch nicht leitende Basisstruktur (B) verwendet wird und darauf eine elektrische Schaltung oder eine elektronische Schaltung (1b) gebildet wird, wobei ein oder mehrere Oberflächenbereiche der Basisstruktur (B) als topographische Struktur ausgebildet sind; dass mindestens ein Oberflächenbereich, welcher die topographische Struktur aufweist, als solcher mit elektrisch leitfähigen Metallschichten bedeckt wird, um ein Thermoelement zu bilden; dass eine erste Metallschicht (M1) in einem ersten Einfallswinkel, der in Bezug auf eine Oberflächenebene nicht 90° beträgt, auf die topographische Struktur aufgebracht wird; dass eine zweite Metallschicht (M2) in einem zweiten Einfallswinkel, der nicht 90° beträgt und sich von dem ersten Einfallswinkel unterscheidet, auf die Struktur aufgebracht wird; dass bewirkt wird, dass sich die erste und zweite Metallschicht (M1; M2) auf diskreten Oberflächenteilen der topographischen Struktur überlappen; um das Thermoelement zu bilden; dass die erste Metallschicht (M1) und die zweite Metallschicht (M2) aus Metallen bestehen, welche für die Funktion des Thermoelements an den diskreten Oberflächenteilen sorgen; dass der Detektor (3) in einem begrenzten Oberflächenbereich der Basisstruktur (B) gebildet wird; dass elektrische Leiter und/oder die elektrischen Schaltungen und/oder die elektronischen Schaltungen (1b) in Nachbarschaft zu dem begrenzten Oberflächenbereich auf dieselbe Weise durch Beschichten einer topographischen Struktur mit einer oder mehreren Metallschichten aus verschiedenen Winkeln gebildet werden; und dass die topographische Struktur so gebildet wird, dass erforderliche Verbindungsflächen bereitgestellt werden, welche zu dem Detektor (3), den elektrischen Leitern und/oder elektrischen und/oder elektronischen Schaltungen (1 b) gehören.

2. Verfahren nach Anspruch 1, **dadurch gekennzeichnet, dass** das Thermoelement so gebildet wird; dass es ein Bolometer ausbildet.

3. Verfahren nach Anspruch 1, wobei die Gaszelle (2) gebildet wird, indem ein erstes (2A) und ein zweites (2B) Teil verwendet werden, welche zusammen den Hohlraum (21) bilden, **dadurch** gekenntzeichnet, dass das erste Teil (2A) auf die Basisstruktur aufgebracht wird.

4. Verfahren nach Anspruch 1, wobei die Gaszelle (2) gebildet wird, indem ein erstes (2A) und ein zweites (2B) Teil verwendet werden, welche zusammen den Hohlraum (21) definieren, **dadurch gekennzeichnet, dass** die Basisstruktur (B) als ein Teil gebildet wird, das mit dem zweiten Teil (2B) integriert ausgebildet ist; und dass Oberflächenteile als ein Teil des inneren Abschnitts oder der Innenfläche des Hohlraums (21) ausgebildet sind.

5. Verfahren nach Anspruch 1, **dadurch gekennzeichnet, dass** die topographische Struktur eine Anzahl von leitfähigen Schwellen umfasst; wobei eine leitfähige Oberfläche sich zwischen zwei benachbarten leitfähigen Schwellen befindet; und wobei die obere Oberfläche entsprechender leitfähiger Schwellen mit einer Wärme absorbierenden Schicht bedeckt ist, die aus Kohlenstoff besteht, und die mittleren leitfähigen Oberflächen mit einer Wärme reflektierenden Schicht bedeckt sind, die aus den Metallschichten besteht.

6. Verfahren nach Anspruch 1, **dadurch gekennzeichnet, dass** eine Metallschicht (M1; M2) in einer von zwei Metallschichten (M1, M2) in Bezug auf die Lichtstrahlen einen ersten Reflektionskoeffizienten aufweist, dass eine Metallschicht (M1; M2) in der anderen von zwei Metallschichten (M1, M2) in Bezug auf die Lichtstrahlen einen zweiten Reflektionskoeffizienten aufweist, und dass ein mit dem Detektor verbundenes Oberflächenteil auf der Basisstruktur (B) relativ zu einfallenden Lichtstrahlen derart angeordnet ist, dass ein Metall, weiches den niedrigsten der beiden Reflektionskoeffizienten aufweist, das Metall ist, welches eine Seitenfläche bedeckt, auf welche die einfallenden Lichtstrahlen treffen.

7. Verfahren nach Anspruch 1, **dadurch gekennzeichnet, dass** sich ein verwendetes Metall in einer ersten Metallschicht von einem verwendeten Metall in einer zweiten Metallschicht unterscheidet, um einen thermoelektrischen Effekt zwischen der ersten und zweiten Metallschicht zu erhalten.

8. Verfahren nach Anspruch 1 oder 7, **dadurch gekennzeichnet, dass** zwei Metallschichten aus mit Gold bedecktem Chrom bestehen.

9. Verfahren nach Anspruch 1, **dadurch gekennzeichnet, dass** ein auf eine erste Gaszelle bezogenes Wandteil (2A) einen Oberflächenbereich (2B) bedeckt, der für zwei oder mehr verschiedene Detektoren (3) vorgesehen ist.

10. Verfahren nach Anspruch 1, **dadurch gekennzeichnet, dass** ein auf eine erste Gaszelle bezogenes Wandteil (2A) einen Oberflächenbereich aufweist, der für zwei oder mehr verschiedene Detektoren (3) vorgesehen ist.

11. Detektoranordnung, welche einen Gassensor (1) in Form einer Gaszelle (2), die einen definierten inneren Hohlraum (21) umfasst, der Öffnungen (21A, 21A', 21 B) umfasst, durch welche ein Volumen eines Gases (G), welches gemessen oder ausgewertet werden soll, eingefüllt und dort belassen wird; eine Vorrichtung (1a) zum Erzeugen von Infrarotlichtstrahlen (4) und zum Leiten der Lichtstrahlen (4) in den Hohlraum (21), wobei bewirkt wird, dass die Lichtstrahlen (4) wiederholt an sich gegenüberliegenden inneren Abschnitten (21C, 21D und 21E) reflektiert werden, welche den inneren Hohlraum (21) definieren; einen Detektor (3) zum Empfang der reflektierten Lichtstrahlen (4) und eine oder mehrere elektrische Schaltungen oder elektronische Schaltungen (1b) umfasst, welche dafür geeignet sind, die Intensität der so empfangenen Lichtstrahlen (4) auszuwerten und die Eigenschaften und/oder die Konzentration des Gases (G) auf der Grundlage der Intensität der Lichtstrahlen (4) auszuwerten, die von der Vorrichtung (1a) zum Erzeugen von Infrarotlichtstrahlen (4) ausgesendet werden, wobei die Gaszelle (2) und ihre inneren Abschnitte als Wandteile ausgebildet sind, welche mit unterschiedlichen Metallschichten bedeckt sind, um eine Oberfläche zu bilden, welche für die Lichtstrahlen als elektromagnetische Wellen stark reflektierend ist, und wobei der Detektor (3) als Thermoelement oder thermoelektrisches Element ausgebildet ist, welches Wärme erfasst, die von Lichtstrahlen erzeugt wird, die durch den Hohlraum (21) und das Gas hindurch gelangen, **dadurch gekennzeichnet, dass** auf einer elektrisch nicht leitenden Basisstruktur (B) und einem Teil derselben eine elektrische Schaltung oder eine elektronische Schaltung (1b) ausgebildet ist, wobei ein oder mehrere Oberflächenbereiche der Basisstruktur (B) als topographische Struktur ausgebildet sind; dass mindestens ein Oberflächenbereich, welcher die topographische Struktur aufweist, mit elektrisch leitfähigen Metallschichten (M1, M2) bedeckt wird, um das Thermoelement zu bilden; dass eine erste Metallschicht (M1) in einem ersten Einfallswinkel, der in Bezug auf eine Oberflächenebene nicht 90° beträgt, auf die topographische Struktur aufgebracht ist; dass eine zweite Metallschicht (M2) in einem zweiten Einfallswinkel, der nicht 90° beträgt und sich von dem ersten Einfallswinkel unterscheidet, auf die Strukturen aufgebracht wird; dass bewirkt wird, dass sich die erste und zweite Metallschicht auf diskreten Oberflächenteilen der topographischen Struktur gegenseitig überlappen, um das Thermoelement zu bilden; dass die erste und die zweite Metallschicht (M1, M2) aus Metallen bestehen, welche für die Funktion des Thermoelements an den diskreten Oberflächenteilen sorgen; dass der Detektor (3) in einem begrenzten Oberflächenbereich der Basisstruktur (B) ausgebildet ist; dass elektrische Leiter und/oder die elektrischen Schaltungen und/oder die elektronischen Schaltungen in Nachbarschaft zu dem begrenzten Oberflächenbereich auf dieselbe Weise durch Beschichten einer topographischen Struktur mit einer oder mehreren Metallschichten aus verschiedenen Winkeln bereitgestellt werden; und dass die topographische Struktur dafür geeignet ist, dass erforderliche Verbindungsflächen bereitgestellt werden, welche zu dem Detektor, den elektrischen Leitern und/oder elektrischen und/oder elektronischen Schaltungen (1b) gehören.

12. Detektoranordnung nach Anspruch 11, **dadurch gekennzeichnet, dass** das Thermoelement als in Reihe geschaltete Widerstände ausgebildet ist und als Bolometer fungiert.

13. Detektoranordnung nach Anspruch 11, wobei eine Gaszelle aus einem ersten (2A) und einem zweiten (2B) Teil besteht, welche miteinander zusammenwirken sollen, um den Hohlraum (21) zu bilden, **dadurch gekennzeichnet, dass** das erste Teil (2A) auf die Basisstruktur (B) aufgebracht und auf dieser befestigt ist.

14. Detektoranordnung nach Anspruch 11, wobei die Gaszelle (2) aus einem ersten (2A) und einem zweiten (2B) Teil besteht, welche miteinander zusammenwirken sollen, um den Hohlraum (21) zu bilden, **dadurch** gekenntzeichnet, dass die Basisstruktur einen integrierten Teil des zweiten Teils (2B) bildet; und dass Oberflächenteile einen integrierten Teil der Innenfläche des Hohlraums (21) bilden.

15. Detektoranordnung nach Anspruch 11, **dadurch gekennzeichnet, dass** die topographische Struktur eine Anzahl von leitfähigen Schwellen umfasst; wobei eine leitfähige Oberfläche sich zwischen zwei benachbarten leitfähigen Schwellen befindet; und wobei die obere Oberfläche entsprechender leitfähiger Schwellen mit einer Wärme absorbierenden Schicht bedeckt ist, die aus Kohlenstoff besteht, und die mittleren leitfähigen Oberflächen mit einer Wärme reflektierenden Schicht bedeckt sind, die aus den Metallschichten besteht.

16. Detektoranordnung nach Anspruch 11, **dadurch gekennzeichnet, dass** eine Metallschicht in einer von zwei Metallschichten in Bezug auf die Lichtstrahlen einen ersten Reflektionskoeffizienten aufweist, dass eine Metallschicht in der anderen von zwei Metallschichten in Bezug auf die Lichtstrahlen einen zweiten Reflektionskoeffizienten aufweist, und dass ein mit dem Detektor verbundenes Oberflächenteil relativ zu einfallenden Lichtstrahlen derart angeordnet ist, dass ein Metall, welches den niedrigsten der beiden Reflektionskoeffizienten aufweist, das Metall ist, welches eine Seitenfläche bedeckt, auf welche die einfallenden Lichtstrahlen treffen.

17. Detektoranordnung nach Anspruch 11, **dadurch gekennzeichnet, dass** sich ein Metall einer ersten Metallschicht von einem Metall einer zweiten Metallschicht unterscheidet, um einen thermoelektrischen Effekt zwischen der ersten und zweiten Metallschicht zu erhalten, und dass die beiden Metallschichten aus mit Gold bedecktem Chrom bestehen.

18. Detektoranordnung nach Anspruch 11, **dadurch gekennzeichnet, dass** ein auf eine erste Gaszelle bezogenes Wandteil (2A) einen Oberflächenbereich (2B) bedeckt, der für zwei oder mehr verschiedene Detektoren (3) vorgesehen ist.

19. Detektoranordnung nach Anspruch 11, **dadurch gekennzeichnet, dass** ein auf eine erste Gaszelle bezogenes Wandteil (2A) einen Oberflächenbereich aufweist, der für zwei oder mehr verschiedene Detektoren (3) vorgesehen ist.

## Revendications

1. Procédé de mise en forme d'un agencement de détecteur, comprenant un capteur de gaz (1), sous forme d'une cellule à gaz (2), présentant une cavité intérieure définie (21), qui comprend des ouvertures (21A ; 21A' ; 21B), à travers lesquelles un volume de gaz (G), à mesurer ou évaluer, doit être fait entrer et être fait sortir ; un dispositif (1a) pour générer des rayons lumineux infrarouges (4) et pour diriger lesdits rayons lumineux (4) dans ladite cavité (21), lesdits rayons lumineux (4) étant amenés à se réfléchir à plusieurs reprises sur des sections intérieures mutuellement opposées (21C, 21D et 21E) définissant ladite cavité intérieure (21) ; un détecteur (3) pour recevoir lesdits rayons lumineux (4) réfléchis ; et un ou plusieurs circuits électriques ou circuits électroniques (1b), adaptés pour évaluer l'intensité des rayons lumineux (4) ainsi reçus et pour évaluer les propriétés et/ou la concentration du gaz (G) sur la base de l'intensité des rayons lumineux (4) transmis par ledit dispositif (1a) pour générer des rayons lumineux infrarouges (4), ladite cellule à gaz (2) et ses sections intérieures étant formées en tant que parties de paroi, recouvertes de différentes couches métalliques pour former une surface qui est hautement réfléchissante en ce qui concerne lesdits rayons lumineux, en tant qu'ondes électromagnétiques, et ledit détecteur (3) étant formé en tant qu'élément thermique ou thermoélectrique, détectant de la chaleur générée par des rayons lumineux passant dans la cavité (21) et ledit gaz, **caractérisé par** l'utilisation d'une structure de base non conductrice électriquement (B), et pour former sur celle-ci un circuit électrique ou un circuit électronique (1b), une ou plusieurs régions de surface de ladite structure de base (B) est/sont formée(s) en tant que structure topographique ; en ce qu'au moins une région de surface ou des régions de surface, présentant ladite structure topographique, est/sont à recouvrir en soi avec des couches métalliques conductrices électriquement pour former un thermocouple, en ce qu'une première couche métallique (M1) doit être appliquée sur la structure topographique selon un premier angle d'incidence, autre que 90° par rapport à un plan de surface ; en ce qu'une seconde couche métallique (M2) doit être appliquée sur ladite structure selon un second angle d'incidence autre que 90° ; et différent dudit premier angle, en ce que ladite première et ladite seconde couches métalliques (M1 ; M2) sont amenées à se chevaucher l'une l'autre à l'intérieur de parties de surface discrètes de ladite structure topographique pour former ledit thermocouple, en ce que ladite première couche métallique (M1) et ladite seconde couche métallique (M2) comprennent des métaux qui fournissent la fonction dudit thermocouple sur lesdites parties de surface discrètes, en ce que ledit détecteur (3) est formé à l'intérieur d'une région de surface limitée de ladite structure de base (B) ; et en ce que des conducteurs électriques et/ou ledit circuit électrique et/ou ledit circuit électronique (1b) sont formés adjacents à ladite région de surface limitée, de la même manière en revêtant une structure topographique d'une ou plusieurs couche(s) métalliques depuis des angles différents, en ce que ladite structure topographique est formée pour fournir des supports de connexion nécessaires, appartenant auxdits détecteurs (3), conducteurs électriques, et/ou circuits électriques et/ou électroniques (1b).

2. Procédé selon la revendication 1, **caractérisé en ce que** ledit élément thermoélectrique est formé pour exposer un bolomètre.

3. Procédé selon la revendication 1, dans lequel ladite cellule à gaz (2) est formée en utilisant une première (2A) et une seconde (2B) parties, qui ensemble forment ladite cavité (21), **caractérisé en ce que** sur ladite structure de base est appliquée ladite première partie (2A).

4. Procédé selon la revendication 1, dans lequel ladite cellule à gaz (2) est formée en utilisant une première (2A) et une seconde (2B) parties, qui ensemble définissent ladite cavité (21), **caractérisé en ce que** ladite structure de base (B) est formée en tant que partie intégrante avec ladite seconde partie (2B) ; et **en ce que** des parties de surface sont formées en tant que partie de la section ou surface intérieure de ladite cavité (21).

5. Procédé selon la revendication 1, **caractérisé en ce que** la structure topographique comprend un nombre d'arêtes conductrices ; une surface conductrice étant située entre deux arêtes conductrices adjacentes ; et la surface supérieure d'arêtes conductrices respectives étant recouverte d'une couche absorbant la chaleur comprenant du carbone, et les surfaces conductrices intermédiaires étant recouvertes avec une couche réfléchissant la chaleur comprenant lesdites couches métalliques.

6. Procédé selon la revendication 1, **caractérisé en ce qu'**une couche métallique (M1 ; M2), dans l'une de deux couches métalliques (M1, M2), présente un premier coefficient de réflexion par rapport auxdits rayons lumineux, **en ce qu'**une couche métalliques (M1 ; M2), dans l'autre de deux couches métalliques (M1, M2), présente un second coefficient de réflexion, par rapport auxdits rayons lumineux, et **en ce qu'**une partie de surface associée au détecteur sur ladite structure de base (B), est positionnée par rapport aux rayons lumineux incidents. de sorte qu'un métal présentant un coefficient de réflexion le plus bas desdits deux coefficients de réflexion est le métal recouvrant une surface latérale, qui fera face auxdits rayons lumineux incidents.

7. Procédé selon la revendication 1, **caractérisé en ce qu'**un métal utilisé dans une première couche métallique est différent d'un métal utilisé dans une seconde couche métallique, de façon à obtenir un effet thermoélectrique, entre ladite première et ladite seconde couches métalliques.

8. Procédé selon la revendication 1 ou 7, **caractérisé en ce que** lesdites deux couches métalliques comprennent de l'or recouvrant du chrome.

9. Procédé selon la revendication 1, **caractérisé en ce qu'**une première partie de paroi (2A) affiliée à la cellule à gaz recouvre une section de surface (2B) prévue pour deux ou plus de détecteurs différents (3).

10. Procédé selon la revendication 1, **caractérisé en ce qu'**une première paroi (2A) affiliée à une partie de cellule à gaz présente une section de surface prévue pour deux ou plus de détecteurs (3).

11. Agencement de détecteur, comprenant un capteur de gaz (1), sous forme d'une cellule à gaz (2), présentant une cavité intérieure définie (21), qui comprend des ouvertures (21A, 21A' ; 21B), à travers lesquelles un volume de gaz (G), à mesurer ou à évaluer, doit être fait entrer et être fait sortir ; un dispositif (1a) pour générer des rayons lumineux infrarouges (4) et pour diriger lesdits rayons lumineux (4) dans ladite cavité (21), lesdits rayons lumineux (4) étant amenés à se réfléchir à plusieurs reprises sur des sections intérieures mutuellement opposées (21C, 21D et 21E) définissant ladite cavité intérieure (21) ; un détecteur (3) pour recevoir lesdits rayons lumineux (4) réfléchis ; et un ou plusieurs circuits électriques ou circuits électroniques (1 b), adapté(s) pour évaluer l'intensité des rayons lumineux (4) ainsi reçus et pour évaluer les propriétés et/ou la concentration du gaz (G) sur la base de l'intensité des rayons lumineux (4), transmis par ledit dispositif (1a), ladite cellule à gaz (2) et ses sections intérieures étant formées en tant que parties de paroi recouvertes avec différentes couches métalliques pour former une surface, qui est hautement réfléchissante en ce qui concerne lesdits rayons lumineux en tant qu'ondes électromagnétiques, et ledit détecteur (3) étant formé en tant qu'élément thermique ou thermoélectrique, détectant de la chaleur générée par des rayons lumineux passant dans ladite cavité (21) et ledit gaz, **caractérisé en ce que** sur une structure de base non conductrice électriquement (B) et une partie de celle-ci, est formé un circuit électrique ou un circuit électronique (1b), une ou plusieurs régions de surface de ladite structure de base (B) est/sont formée(s) en tant que structure topographique ; **en ce qu'**au moins une région de surface ou des régions de surface, présentant ladite structure topographique, est/sont recouverte(s) avec des couches métalliques conductrices électriquement (M1, M2) pour former ledit élément thermoélectrique; **en ce qu'**une première couche métallique (M1) est appliquée sur la structure topographique selon un premier angle d'incidence, autre que 90° par rapport à un plan de surface ; **en ce qu'**une seconde couche métallique (M2) est appliquée sur lesdites structures selon un second angle, autre que 90° et différent dudit premier angle d'incidence, avec quoi ladite première et ladite seconde couches métalliques se chevauchent mutuellement l'une l'autre à l'intérieur de parties de surface discrètes de ladite structure topographique, pour former ledit thermocouple, **en ce que** ladite première et ladite seconde couches métalliques (M1, M2) comprennent des métaux qui fournissent la fonction dudit thermocouple sur lesdites parties de surface discrètes, **en ce que** ledit détecteur (3) est formé à l'intérieur d'une zone de surface limitée de ladite structure de base (B) ; et **en ce que** des conducteurs électriques et/ou lesdits circuits électriques et/ou lesdits circuits électroniques sont fournis adjacents à ladite zone de surface limitée de la même manière en revêtant une structure topographique d'une ou plusieurs couches métalliques (M1, M2) depuis différents angles, **en ce que** ladite structure topographique est adaptée pour fournir des supports de connexion nécessaires, appartenant auxdits détecteur, pistes conductrices électriques, et/ou circuits électriques et/ou électroniques.

12. Agencement de détecteur selon la revendication 11, **caractérisé en ce que** ledit élément thermique est formé en tant que résistances branchées en série et fonctionne en tant que bolomètre.

13. Agencement de détecteur selon la revendication 11, dans lequel une cellule à gaz comprend une première (2A) et une seconde (2B) parties, qui sont prévues pour coopérer l'une avec l'autre pour former ladite cavité (21), **caractérisé en ce que** sur ladite structure de base (B) est appliquée et attachée ladite première partie (2A).

14. Agencement de détecteur selon la revendication 11, dans lequel ladite cellule à gaz (2) comprend une première (2A) et une seconde (2B) parties, qui sont prévues pour coopérer pour former ladite cavité (21), **caractérisé en ce que** ladite structure de base forme une partie intégrante de ladite seconde partie (2B) ; et **en ce que** des parties de surface forment une partie intégrante de la surface intérieure de ladite cavité (21).

15. Agencement de détecteur selon la revendication 11, **caractérisé en ce que** la structure topographique comprend un nombre d'arêtes conductrices ; une surface conductrice étant située entre deux arêtes conductrices adjacentes ; et la surface supérieure d'arêtes conductrices respectives étant recouverte avec une couche absorbant la chaleur comprenant du carbone, et les surfaces conductrices intermédiaires étant recouvertes avec une couche réfléchissant la chaleur comprenant lesdites couches métalliques.

16. Agencement de détecteur selon la revendication 11, **caractérisé en ce qu'**une couche métallique dans l'une de deux couches métalliques présente un premier coefficient de réflexion, par rapport auxdits rayons lumineux, **en ce qu'**une couche métallique dans l'autre de deux couches métalliques présente un second coefficient de réflexion, par rapport auxdits rayons lumineux, et **en ce qu'**une partie de surface associée au détecteur est positionnée par rapport à des rayons lumineux incidents, de sorte que le métal avec un coefficient de réflexion le plus faible desdits deux coefficients de réflexion est le métal recouvrant une surface latérale qui fera face auxdits rayons lumineux incidents.

17. Agencement de détecteur selon la revendication 11, **caractérisé en ce qu'**un métal d'une première couche métallique est différent d'un métal d'une seconde couche métallique, de façon à obtenir un effet thermoélectrique entre ladite première et ladite seconde couches métalliques et **en ce que** lesdites deux couches métalliques comprennent de l'or recouvrant du chrome.

18. Agencement de détecteur selon la revendication 11, **caractérisé en ce qu'**une première partie de paroi (2A) affiliée à la cellule à gaz recouvre une section de surface (2B) prévue pour deux ou plus de détecteurs (3).

19. Agencement de détecteur selon la revendication 11, **caractérisé en ce que** ladite première partie de paroi (2A) affiliée à la cellule à gaz présente une section de surface prévue pour un ou plusieurs détecteurs (3).
